# EUROPÄISCHE PATENTANMELDUNG

(11) **EP 4 349 641 A1**
(43) Veröffentlichungstag der Anmeldung: **10.04.2024**
(21) Anmeldenummer: 23186685.6
(22) Anmeldetag: 20.07.2023
(51) Int. Cl.: B60L 53/62, B60L 53/66, B60L 53/68

(54) **ERMITTLUNGSVERFAHREN, ERMITTLUNGSSYSTEM UND KRAFTFAHRZEUG**

(30) Priorität: 07.10.2022 DE 102022210621
(71) Anmelder: VOLKSWAGEN AG, 38440 Wolfsburg (DE)
(72) Erfinder: Rackow, Christian, 38446 Wolfsburg (DE); Motta, Riccardo, 38440 Wolfsburg (DE); Kreißl, Holger, 38126 Braunschweig (DE); Djatschenko, Alexander, 38550 Isenbüttel (DE); Ludewig, Bernhard, 39126 Magdeburg (DE)

(57) **Zusammenfassung**

Die vorliegende Erfindung betrifft ein Ermittlungsverfahren (200) zum Ermitteln einer Differenz zwischen einer maximal möglichen Empfangsleistung (110) eines Kraftfahrzeugs (100) und einer aktuellen Ladeleistung (20) eines Ladevorgangs durch ein Ermittlungssystem (10), das Ermittlungsverfahren (200) umfassend:
- Erfassen (202) der aktuellen Ladeleistung (20) durch eine Erfassungsvorrichtung (30) des Ermittlungssystems (10),
- Ermitteln (204) einer Differenz zwischen der maximal möglichen Empfangsleistung (110) des Kraftfahrzeugs (100) und der erfassten aktuellen Ladeleistung (20), wobei die erfasste Ladeleistung (20) mit der maximal möglichen Empfangsleistung (110) des Kraftfahrzeugs (100) durch eine Vergleichsvorrichtung (40) des Ermittlungssystems (10) verglichen wird,
- Ausgeben (206) einer Differenzmeldung auf Grundlage der ermittelten Differenz durch eine Ausgabevorrichtung (50) des Ermittlungssystems (10), wenn die erfasste Ladeleistung (20) geringer als die maximal mögliche Empfangsleistung (110) ist.

Ferner betrifft die Erfindung ein Ermittlungssystem (10) und ein Kraftfahrzeug (100) mit einem Ermittlungssystem (10).

## Beschreibung

Die vorliegende Erfindung betrifft ein Ermittlungsverfahren zum Ermitteln einer Differenz zwischen einer maximal möglichen Empfangsleistung eines Kraftfahrzeugs und einer aktuellen Ladeleistung eines Ladevorgangs durch ein Ermittlungssystem. Ferner betrifft die Erfindung ein Ermittlungssystem zum Ausführen des Ermittlungsverfahrens. Auch betrifft die Erfindung ein Kraftfahrzeug mit einem Ermittlungssystem.

Die derzeitig öffentlich bekannten elektrisch oder teilelektrisch angetriebenen Kraftfahrzeuge im Stand der Technik weisen zunehmend größere maximal mögliche Empfangsleistungen für die elektrischen Speichervorrichtungen der Kraftfahrzeuge auf. Die maximal mögliche Empfangsleistung der elektrischen Speichervorrichtung ist neben der ermöglichten Reichweite durch die Speichervorrichtung eine zunehmend relevante Kenngröße für eine Kaufentscheidung und/oder Bewertung eines Kraftfahrzeugs.

In der Praxis stehen für den Ladevorgang des Kraftfahrzeugs unterschiedliche Ladestationen und Schnell-Ladestationen von unterschiedlichsten Ladepunktbetreibern zur Verfügung. Die Ladestationen werden häufig mit hohen erreichbaren Ladeleistungen beworben, wobei zumeist praktisch aus den unterschiedlichsten Gründen die zur Verfügung gestellte Ladeleistung unter den maximal möglichen Empfangsleistungen der Kraftfahrzeuge verbleibt. Beispielsweise werden Ladestationen in ihrer zur Verfügung stehenden Ladeleistung gedrosselt, wenn die vorgelagerte Netzinfrastruktur die Leistung nicht zur Verfügung stellen kann.

Nachteilig ist dabei, dass einem Kraftfahrzeug Anwender der Umstand der geringeren Ladeleistung zwar möglicherweise durch eine höhere Ladedauer auffällt, jedoch ist dieser Umstand für den Anwender erst rückschauend erkennbar. Ferner fehlt dem Anwender eine Information darüber, ob die maximal mögliche Empfangsleistung des Kraftfahrzeugs von der genutzten Ladeinfrastruktur ausgenutzt wird. Der Anwender des Kraftfahrzeugs wird folglich uninformiert zurückgelassen und im Zweifel das Problem für die verminderte Ladeleistung beim Kraftfahrzeug vermuten.

Es ist daher Aufgabe der vorliegenden Erfindung, die oben beschriebenen Nachteile im Stand der Technik zu beheben oder zumindest teilweise zu beheben. Insbesondere ist es Aufgabe der Erfindung, ein Ermittlungsverfahren zum Ermitteln einer Differenz zwischen einer maximal möglichen Empfangsleistung eines Kraftfahrzeugs und einer aktuellen Ladeleistung eines Ladevorgangs durch ein Ermittlungssystem bereitzustellen, mit dem das Ermitteln und Ausgeben einer Differenz zwischen einer maximal möglichen Empfangsleistung eines Kraftfahrzeugs und einer aktuellen Ladeleistung eines Ladevorgangs besonders einfach ermöglicht wird. Insbesondere ist es ferner die Aufgabe der Erfindung ein Ermittlungssystem zum Ausführen des Ermittlungsverfahrens sowie ein Kraftfahrzeug mit einem Ermittlungssystem bereitzustellen.

Die voranstehende Aufgabe wird durch die Patentansprüche gelöst. Insbesondere wird die Aufgabe gelöst durch ein Ermittlungsverfahren mit den Merkmalen des unabhängigen Anspruchs 1. Ferner wird die Aufgabe gelöst durch ein Ermittlungssystem mit den Merkmalen des unabhängigen Anspruchs 10 und durch ein Kraftfahrzeug mit den Merkmalen des unabhängigen Anspruchs 11. Weitere Vorteile und Details der Erfindung ergeben sich aus den Unteransprüchen, der Beschreibung und den Zeichnungen. Dabei gelten Merkmale, die im Zusammenhang mit dem erfindungsgemäßen Ermittlungsverfahren beschrieben sind, selbstverständlich auch im Zusammenhang mit dem erfindungsgemäßen Ermittlungssystem, dem erfindungsgemäßen Kraftfahrzeug und jeweils umgekehrt, sodass bezüglich der Offenbarung zu den einzelnen Erfindungsaspekten stets wechselseitig Bezug genommen wird beziehungsweise werden kann.

Gemäß einem ersten Aspekt der Erfindung wird die Aufgabe gelöst durch ein Ermittlungsverfahren zum Ermitteln einer Differenz zwischen einer maximal möglichen Empfangsleistung eines Kraftfahrzeugs und einer aktuellen Ladeleistung eines Ladevorgangs durch ein Ermittlungssystem, das Ermittlungsverfahren umfassend:
- Erfassen der aktuellen Ladeleistung durch eine Erfassungsvorrichtung des Ermittlungssystems,
- Ermitteln einer Differenz zwischen der maximal möglichen Empfangsleistung des Kraftfahrzeugs und der erfassten aktuellen Ladeleistung, wobei die erfasste Ladeleistung mit der maximal möglichen Empfangsleistung des Kraftfahrzeugs durch eine Vergleichsvorrichtung des Ermittlungssystems verglichen wird,
- Ausgeben einer Differenzmeldung auf Grundlage der ermittelten Differenz durch eine Ausgabevorrichtung des Ermittlungssystems, wenn die erfasste Ladeleistung geringer als die maximal mögliche Empfangsleistung ist.

Die zuvor und die im Nachfolgenden beschrieben Verfahrensschritte können, wenn nicht explizit anderweitig angegeben, einzeln, zusammen, einfach, mehrfach, zeitlich parallel und/oder nacheinander in beliebiger Reihenfolge ausgeführt werden. Eine Benennung als beispielsweise "erster Verfahrensschritt" und "zweiter Verfahrensschritt" bedingt keine zeitliche Reihenfolge und/oder Priorisierung. Eine bevorzugte Reihenfolge der Verfahrensschritte sieht vor, dass die Verfahrensschritte in der aufgeführten Reihenfolge ausgeführt werden.

Das Erfassen einer aktuellen Ladeleistung ist als Erfassen, Empfangen und/oder Messen der aktuellen Ladeleistung des Ladevorgangs zu verstehen. Die Ladeleistung wird bevorzugt in Intervallen, einfach, mehrfach und/oder kontinuierlich erfasst. Die aktuelle Ladeleistung ist bevorzugt als Energiezufluss an das Kraftfahrzeug, insbesondere an einen Energiespeicher des Kraftfahrzeugs, zu verstehen.

Das Ermitteln einer Differenz zwischen der maximal möglichen Empfangsleistung des Kraftfahrzeugs und der erfassten aktuellen Ladeleistung erfolgt durch einen Vergleich der erfassten Ladeleistung mit der maximal möglichen Empfangsleistung des Kraftfahrzeugs durch eine Vergleichsvorrichtung. Die maximal mögliche Empfangsleistung ist bevorzugt vom Hersteller definiert, auf einer Speichereinheit des Ermittlungssystems und/oder des Kraftfahrzeugs gespeichert, durch das Ermittlungssystem erfassbar und/oder von dem Energiespeicher des Kraftfahrzeugs an das Ermittlungssystem kommunizierbar. Bevorzugt ist die maximal mögliche Empfangsleistung als Funktion der Empfangsleistung über die Zeit, über eine definierte Lebensdauer des Energiespeichers und/oder über eine Temperatur des Energiespeichers zu verstehen. Die Vergleichsvorrichtung ist bevorzugt als Rechnereinheit ausgestaltet, wobei die Rechnereinheit zum Vergleich von den empfangenen und/oder erfassten aktuellen Ladeleistung mit der empfangenen und/oder erfassten maximal möglichen Empfangsleistung ausgestaltet ist. Besonders bevorzugt ist die Vergleichsvorrichtung als gemeinsame Funktionseinheit des Ermittlungssystems und des Kraftfahrzeugs ausgestaltet, wobei vorteilhaft durch die Vergleichsvorrichtung Rechenleistung für das Ermittlungssystem und das Kraftfahrzeug bereitgestellt wird.

Das Ausgeben der Differenzmeldung erfolgt durch eine Ausgabevorrichtung. Die Ausgabevorrichtung ist im Rahmen der Erfindung als akustische, haptische und/oder optische Ausgabevorrichtung zu verstehen. Bevorzugt umfasst die Ausgabevorrichtung zumindest eine Ausgabeeinheit zur Ausgabe der Differenzmeldung. Bevorzugt umfasst die Ausgabevorrichtung wenigstens zwei Ausgabeeinheiten, wobei die wenigstens zwei Ausgabeeinheiten unterschiedlich ausgestaltet sind. Bevorzugt ist eine erste Ausgabeeinheit zur optischen und/oder grafischen Ausgabe der Differenzmeldung ausgestaltet und eine zweite Ausgabeeinheit zur akustischen Ausgabe der Differenzmeldung ausgestaltet. Besonders bevorzugt ist eine erste Ausgabeeinheit zur grafischen Ausgabe, beispielsweise als grafische Meldung über das Infotainmentsystem des Kraftfahrzeugs, und eine zweite Ausgabeeinheit zur optischen Ausgabe, beispielsweise als Leuchteinheit an und/oder um eine Ladebuchse des Kraftfahrzeugs ausgestaltet. Die Leuchteinheit ist bevorzugt zur Ausgabe der Differenzmeldung in Form von verschiedenen Farben für verschiedene ermittelte Differenzen ausgestaltet.

Das erfindungsgemäße Ausgeben der Differenzmeldung erfolgt, wenn die erfasste Ladeleistung geringer als die maximal mögliche Empfangsleistung ist. Natürlich kann zusätzlich auch eine Informationsmeldung ausgegeben werden, dass die erfasste Ladeleistung der maximal möglichen Empfangsleistung oder im Wesentlichen der maximal möglichen Empfangsleistung entspricht. Die Formulierung "X oder im Wesentlichen X" soll im Rahmen der Erfindung als mögliche, geringe Abweichung, beispielsweise aufgrund von Fertigungstoleranzen, Material- und/oder Prozesseigenschaften verstanden werden, ohne die zugrundeliegende, beabsichtigte Funktion des Merkmals zu verändern.

Bevorzugt umfasst das Ausgeben der Differenzmeldung ein Ausgeben der maximal möglichen Empfangsleistung des Kraftfahrzeugs und/oder einen Hinweis, dass die maximal mögliche Empfangsleistung des Kraftfahrzeugs durch den aktuellen Ladevorgang nicht erreicht und/oder nicht vollständig ausgenutzt wird.

Ein derart ausgestaltetes Ermittlungsverfahren ist besonders vorteilhaft, da das Ermitteln und Ausgeben einer Differenz zwischen einer maximal möglichen Empfangsleistung eines Kraftfahrzeugs und einer aktuellen Ladeleistung eines Ladevorgangs besonders einfach ermöglicht wird. Der Anwender wird somit vorteilhaft informiert, dass der aktuelle Ladevorgang nicht optimal ist.

Gemäß einer bevorzugten Weiterentwicklung der Erfindung kann bei einem Ermittlungsverfahren vorgesehen sein, dass das Ermittlungsverfahren umfasst:
- Detektieren eines Ladevorgangs durch eine Detektionsvorrichtung des Ermittlungssystems, wobei die Verfahrensschritte des Erfassens, des Ermittelns und/oder des Ausgebens in Abhängigkeit von einem detektierten Ladevorgang erfolgen.

Bevorzugt wird das erfindungsgemäße Ermittlungsverfahren, insbesondere die Verfahrensschritte des Erfassens, des Ermittelns und/oder des Ausgebens, in Abhängigkeit von einem detektierten Ladevorgang von dem Ermittlungssystem ausgeführt. Anschaulich beschrieben wird das erfindungsgemäße Ermittlungsverfahren nur bei einem detektierten Ladevorgang ausgeführt, sodass vorteilhaft Ressourcen gespart und/oder anderweitig eingesetzt werden können, wenn kein Ladevorgang detektiert wird. Das Detektieren eines Ladevorgangs wird beispielhaft durch ein Detektieren einer Initiationshandlung ermöglicht, wie beispielhaft dem Öffnen einer Abdeckvorrichtung einer Ladebuchse des Kraftfahrzeugs, dem Einstecken eines Ladesteckers in die Ladebuchse des Kraftfahrzeugs und/oder einem Energiefluss an das Kraftfahrzeug, insbesondere an den Energiespeicher des Kraftfahrzeugs. Ein derart ausgestaltetes Ermittlungsverfahren ist besonders vorteilhaft, da durch die Detektionsvorrichtung das Ermitteln und Ausgeben einer Differenz zwischen einer maximal möglichen Empfangsleistung eines Kraftfahrzeugs und einer aktuellen Ladeleistung eines Ladevorgangs besonders effizient und einfach ermöglicht wird.

Gemäß einer bevorzugten Weiterentwicklung der Erfindung kann bei einem Ermittlungsverfahren vorgesehen sein, dass das Ermitteln der Differenz ferner umfasst:
- Kategorisieren der erfassten aktuellen Ladeleistung in wenigstens zwei Kategorien in Abhängigkeit von der maximal möglichen Empfangsleistung des Kraftfahrzeugs, insbesondere wobei das Ausgeben der Differenzmeldung auf Grundlage des Kategorisierens, erfolgt.

Um die Informationen über die ermittelte Differenz besonders einfach und/oder anschaulich an den Anwender des Kraftfahrzeugs zu übermitteln und/oder dem Anwender zur Verfügung zu stellen, ist es vorteilhaft, wenn die aktuelle Ladeleistung und/oder die daraus ermittelte Differenz in wenigstens zwei Kategorien, bevorzugt wenigstens drei Kategorien, in Abhängigkeit von der maximal möglichen Empfangsleistung des Kraftfahrzeugs kategorisiert werden. Beispielhaft erfolgt die Kategorisierung bei 50% und 90% der erfassten aktuellen Ladeleistung von der maximal möglichen Empfangsleistung des Kraftfahrzeugs. Gemäß dem Beispiel entspricht der Bereich von 90 bis 100% einer ersten Kategorie, der Bereich von 50 bis 89% einer zweiten Kategorie und der Bereich von 0 bis 49% einer dritten Kategorie. Bevorzugt werden die Differenzenmeldungen der unterschiedlichen Kategorien unterschiedlich ausgegeben. Dem voranstehenden Beispiel folgend, wird anschaulich eine Differenzmeldung der Kategorie 90 bis 100 % kleiner, farblich und/oder grafisch unauffälliger, insbesondere grün, als eine Differenzmeldung der Kategorie 50 bis 89% ausgegeben. Die Differenzmeldungen der Kategorie 0 bis 49% werden bevorzugt warnend, blickend, rot und/oder optisch, haptisch und/oder akustisch unterstützt ausgegeben. Die voranstehenden Prozentangaben sind beispielhaft zu verstehen und verdeutlichen eine allgemeine Einteilung und/oder Unterscheidung der Differenzmeldung, wobei die erfasste aktuelle Ladeleistung für die wenigstens zwei Kategorien in Abhängigkeit von der maximal möglichen Empfangsleistung verwendet und/oder berücksichtigt wird. Das Kategorisieren erfolgt bevorzugt durch das Ermittlungssystem, insbesondere durch eine Rechnervorrichtung des Ermittlungssystems. Ein derart ausgestaltetes Ermittlungsverfahren ist besonders vorteilhaft, da durch das Kategorisieren das Ermitteln und differenzierte Ausgeben einer Differenz zwischen einer maximal möglichen Empfangsleistung eines Kraftfahrzeugs und einer aktuellen Ladeleistung eines Ladevorgangs besonders effizient und einfach ermöglicht wird.

Gemäß einer bevorzugten Weiterentwicklung der Erfindung kann bei einem Ermittlungsverfahren vorgesehen sein, dass das Ermittlungsverfahren umfasst:
- Auswerten zumindest einer Sensorvorrichtung des Ermittlungssystems durch eine Auswertevorrichtung des Ermittlungssystems zur Ermittlung von zumindest einem Begrenzungsfaktor für die erfasste aktuelle Ladeleistung, wobei der zumindest eine ermittelte Begrenzungsfaktor durch die Ausgabevorrichtung ausgegeben wird.

Zusätzlich oder alternativ zu den voranstehenden Absätzen ist es besonders vorteilhaft, wenn zu der erfassten aktuellen Ladeleistung ein Begrenzungsfaktor ermittelt wird. Selbstverständlich ist die Ermittlung eines Begrenzungsfaktors abhängig davon, dass und/oder ob die aktuelle Ladeleistung grundsätzlich begrenzt ist. Der zumindest eine Begrenzungsfaktor ist im Rahmen der Erfindung als ein begrenzender Faktor für die aktuelle Ladeleistung des Ladevorgangs zu verstehen. Zur Ermittlung zumindest eines Begrenzungsfaktors weist das Ermittlungssystem bevorzugt zumindest eine Sensorvorrichtung auf. Beispielhaft umfasst die Ermittlung zumindest eines Begrenzungsfaktors das Ermitteln eines elektrischen Widerstands, das Ermitteln eines Leitungsquerschnitts, das Ermitteln einer Verbindungsgüte zwischen dem Kraftfahrzeug und einer Ladeinfrastruktur, das Ermitteln einer bereitgestellten Energie an das Kraftfahrzeug und/oder das Ermitteln einer Temperatur des Kraftfahrzeugs, der Umgebung und/oder der Ladeinfrastruktur. Der ermittelte zumindest eine Begrenzungsfaktor wird vorteilhaft über die Ausgabevorrichtung ausgegeben und somit dem Anwender des Kraftfahrzeugs als zumindest eine mögliche Ursache für eine verringerte Ladeleistung des Ladevorgangs zur Verfügung gestellt. Der Anwender des Kraftfahrzeugs kann somit verbessert beurteilen, durch welchen zumindest einen Begrenzungsfaktor die erfasste Ladeleistung begrenzt wird und somit eine mögliche Reaktion auf den zumindest einen Begrenzungsfaktor vorteilhaft vornehmen. Die Differenzmeldung und der zumindest eine ermittelte Begrenzungsfaktor werden bevorzugt gemeinsam oder separat ausgegeben. Analog zu der Differenzmeldung wird der zumindest eine ermittelte Begrenzungsfaktor über wenigstens eine Ausgabevorrichtung optisch, grafisch, akustisch und/oder haptisch ausgegeben. Ein derart ausgestaltetes Ermittlungsverfahren ist besonders vorteilhaft, da durch das Auswerten zumindest einer Sensorvorrichtung des Ermittlungssystems durch die Auswertevorrichtung des Ermittlungssystems zur Ermittlung von zumindest einem Begrenzungsfaktor für die erfasste aktuelle Ladeleistung das Ermitteln und Ausgeben einer Differenz zwischen einer maximal möglichen Empfangsleistung eines Kraftfahrzeugs und einer aktuellen Ladeleistung eines Ladevorgangs und des zumindest einen ermittelten Begrenzungsfaktors besonders effizient und einfach ermöglicht wird.

Gemäß einer bevorzugten Weiterentwicklung der Erfindung kann bei einem Ermittlungsverfahren vorgesehen sein, dass das Erfassen der aktuellen Ladeleistung und/oder das Ermitteln der maximal möglichen Empfangsleistung durch eine datenkommunizierende Verbindung der Erfassungsvorrichtung mit zumindest einem Energiespeicher des Kraftfahrzeugs erfolgt. Es ist besonders vorteilhaft, wenn das Ermittlungssystem datenkommunizierend mit dem Energiespeicher des Kraftfahrzeugs verbunden ist. Der Energiespeicher des Kraftfahrzeugs übermittelt dem Ermittlungssystem bevorzugt die aktuelle Ladeleistung und/oder die maximal mögliche Empfangsleistung des Kraftfahrzeugs, insbesondere des Energiespeichers. Das Erfassen der aktuellen Ladeleistung erfolgt bevorzugt durch eine Ermittlung einer Spannungsdifferenz durch das Ermittlungssystem und/oder den Energiespeicher. Die maximal mögliche Empfangsleistung des Kraftfahrzeugs und/oder des Energiespeichers ist bevorzugt herstellerseitig definiert und/oder wird durch das Kraftfahrzeug und/oder den Energiespeicher erfasst, insbesondere als Funktion über die Zeit, das Alter des Energiespeichers, die gefahrenen Kilometer des Kraftfahrzeugs und/oder die Temperatur des Energiespeichers. Die voranstehenden und in der weiteren Beschreibung angeführten datenkommunizierenden Verbindungen sind bevorzugt kabelgebunden oder kabellos ausgestaltet. Ein derart ausgestaltetes Ermittlungsverfahren ist besonders vorteilhaft, da durch die datenkommunizierende Verbindung der Erfassungsvorrichtung mit zumindest einem Energiespeicher das Ermitteln und Ausgeben einer Differenz zwischen einer maximal möglichen Empfangsleistung eines Kraftfahrzeugs und einer aktuellen Ladeleistung eines Ladevorgangs besonders effizient und einfach ermöglicht wird.

Gemäß einer bevorzugten Weiterentwicklung der Erfindung kann bei einem Ermittlungsverfahren vorgesehen sein, dass das Erfassen der aktuellen Ladeleistung durch eine datenkommunizierende Verbindung der Erfassungsvorrichtung mit zumindest einer Ladeinfrastrukturvorrichtung erfolgt. Alternativ oder zusätzlich zu dem voranstehenden Absatz ist es vorteilhaft, wenn das Erfassen der aktuellen Ladeleistung durch eine datenkommunizierende Verbindung der Erfassungsvorrichtung mit zumindest einer Ladeinfrastrukturvorrichtung erfolgt. Anschaulich beschrieben stellt die Ladeinfrastrukturvorrichtung dabei bevorzugt die mögliche und/oder aktuell bereitgestellte Ladeleistung der Ladeinfrastrukturvorrichtung an das Ermittlungssystem zur Verfügung und/oder schickt die mögliche und/oder aktuell bereitgestellte Ladeleistung der Ladeinfrastrukturvorrichtung über die datenkommunizierende Verbindung an das Ermittlungssystem. Das Ermittlungssystem hat eine entsprechende Empfangsvorrichtung, insbesondere wobei die Empfangsvorrichtung mit einer Rechnervorrichtung des Ermittlungssystems datenkommunizierend verbunden ist. Ein derart ausgestaltetes Ermittlungsverfahren ist besonders vorteilhaft, da durch die datenkommunizierende Verbindung der Erfassungsvorrichtung mit zumindest einer Ladeinfrastrukturvorrichtung das Ermitteln und Ausgeben einer Differenz zwischen einer maximal möglichen Empfangsleistung eines Kraftfahrzeugs besonders effizient und einfach ermöglicht wird.
Gemäß einer bevorzugten Weiterentwicklung der Erfindung kann bei einem Ermittlungsverfahren vorgesehen sein, dass das Ausgeben der Differenzmeldung auf Grundlage der ermittelten Differenz als eine optische Ausgabe, insbesondere eine grafische Ausgabe, durch die Ausgabevorrichtung erfolgt. Bevorzugt umfasst die Ausgabevorrichtung zumindest eine Ausgabeeinheit zur Ausgabe der Differenzmeldung. Bevorzugt umfasst die Ausgabevorrichtung wenigstens zwei Ausgabeeinheiten, wobei die wenigstens zwei Ausgabeeinheit unterschiedlich ausgestaltet sind. Bevorzugt ist eine erste Ausgabeeinheit zur optischen und/oder grafischen Ausgabe der Differenzmeldung ausgestaltet und eine zweite Ausgabeeinheit zur akustischen Ausgabe der Differenzmeldung ausgestaltet. Besonders bevorzugt ist eine erste Ausgabeeinheit zur grafischen Ausgabe, beispielsweise als grafische Meldung über das Infotainmentsystem des Kraftfahrzeugs, und eine zweite Ausgabeeinheit zur optischen Ausgabe, beispielsweise als Leuchteinheit an und/oder um eine Ladebuchse des Kraftfahrzeugs ausgestalte. Die Leuchteinheit ist bevorzugt zur Ausgabe der Differenzmeldung in Form von verschiedenen Farben für verschiedene ermittelte Differenzen ausgestaltet. Ein derart ausgestaltetes Ermittlungsverfahren ist besonders vorteilhaft, da durch die optische Ausgabe, insbesondere grafische Ausgabe, der Differenzmeldung auf Grundlage der ermittelten Differenz durch die Ausgabevorrichtung das Ermitteln und Ausgeben einer Differenz zwischen einer maximal möglichen Empfangsleistung eines Kraftfahrzeugs besonders vorteilhaft und einfach ermöglicht wird.

Gemäß einer bevorzugten Weiterentwicklung der Erfindung kann bei einem Ermittlungsverfahren vorgesehen sein, dass das Ausgeben der Differenzmeldung auf Grundlage der ermittelten Differenz ein Senden einer Ausgabe an eine Ladeinfrastrukturvorrichtung durch eine Sendevorrichtung des Ermittlungssystems umfasst. Alternativ oder zusätzlich umfasst die Ausgabevorrichtung zumindest eine Schnittstelle zur Ausgabe der Differenzmeldung über eine Ausgabeeinheit eines Ladekabels und/oder einer Ladeinfrastrukturvorrichtung. Die Ausgabe der Differenzmeldung über eine Ladeinfrastrukturvorrichtung erfolgt bevorzugt zusätzlich zur Ausgabe über die Ausgabevorrichtung des Ermittlungssystems. Das Senden der Ausgabe an die Ladeinfrastrukturvorrichtung erfolgt kabellos oder kabelgebunden. Ein derart ausgestaltetes Ermittlungsverfahren ist besonders vorteilhaft, da durch das Senden einer Ausgabe an eine Ladeinfrastrukturvorrichtung das Ausgeben einer Differenz zwischen einer maximal möglichen Empfangsleistung eines Kraftfahrzeugs besonders vorteilhaft und einfach ermöglicht wird.

Gemäß einer bevorzugten Weiterentwicklung der Erfindung kann bei einem Ermittlungsverfahren vorgesehen sein, dass das Ermittlungsverfahren ferner umfasst:
- Initiieren einer datenkommunizierenden Verbindung zwischen dem Ermittlungssystem und einem mobilen Endgerät, wobei das Ausgeben der Differenzmeldung ein Senden einer Ausgabe an das mobile Endgerät umfasst.

Ein mobiles Endgerät ist im Rahmen der Erfindung als ein Handy, ein Tablet, eine Armbanduhr und/oder ein anderweitiges mobiles Endgerät zu verstehen. Ein Initiieren einer datenkommunizierenden Verbindung zwischen dem Ermittlungssystem und dem mobilen Endgerät ist besonders vorteilhaft, da die Differenzmeldung durch das Senden einer Ausgabe an das mobile Endgerät dem Anwender vorteilhaft zur Verfügung gestellt werden kann. Somit kann die Differenzmeldung dem Anwender auch zur Verfügung gestellt werden, wenn sich der Anwender bereits von dem Kraftfahrzeug entfernt hat. Bevorzugt wird die datenkommunizierende Verbindung zwischen dem Ermittlungssystem und dem mobilen Endgerät nur dann initiiert, wenn ein Ladevorgang detektiert worden ist. Somit werden vorteilhaft Ressourcen effizient eingesetzt und unnötige Verbindungen zwischen dem Ermittlungssystem und dem mobilen Endgerät vermindert oder sogar vermieden. Ein derart ausgestaltetes Ermittlungsverfahren ist besonders vorteilhaft, da durch das Initiieren der datenkommunizierenden Verbindung zwischen dem Ermittlungssystem und dem mobilen Endgerät, sowie durch das Senden einer Ausgabe an das mobile Endgerät, das Ausgeben einer Differenz zwischen einer maximal möglichen Empfangsleistung eines Kraftfahrzeugs besonders vorteilhaft und einfach ermöglicht wird.

Gemäß einem zweiten Aspekt der Erfindung wird die Aufgabe durch ein Ermittlungssystem gelöst. Das Ermittlungssystem weist eine Erfassungsvorrichtung zum Erfassen der aktuellen Ladeleistung, eine Vergleichsvorrichtung zum Vergleichen der erfassten Ladeleistung mit einer maximal möglichen Empfangsleistung des Kraftfahrzeugs zum Ermitteln einer Differenz zwischen der maximal möglichen Empfangsleistung des Kraftfahrzeugs und der erfassten aktuellen Ladeleistung und eine Ausgabevorrichtung zum Ausgeben einer Differenzmeldung auf Grundlage der ermittelten Differenz auf. Das Ermittlungssystem ist zum Ausführen des Ermittlungsverfahrens gemäß dem ersten Aspekt ausgestaltet. Bei dem beschriebenen Ermittlungssystem ergeben sich sämtliche Vorteile, die bereits zu dem Ermittlungsverfahren gemäß dem ersten Aspekt der Erfindung beschrieben worden sind. Optional weist das Ermittlungssystem ferner eine Sensorvorrichtung, eine Auswertevorrichtung und/oder eine Sendevorrichtung gemäß den voranstehenden Abschnitten auf. Ein derart ausgestaltetes Ermittlungssystem ist besonders vorteilhaft, da das Ausgeben einer Differenz zwischen einer maximal möglichen Empfangsleistung eines Kraftfahrzeugs besonders vorteilhaft und einfach ermöglicht wird.

Gemäß einem dritten Aspekt der Erfindung wird die Aufgabe durch ein Kraftfahrzeug mit einem Ermittlungssystem gelöst. Das Ermittlungssystem ist gemäß dem zweiten Aspekt ausgestaltet. Bei dem beschriebenen Kraftfahrzeug ergeben sich sämtliche Vorteile, die bereits zu dem Ermittlungssystem gemäß dem zweiten Aspekt der Erfindung und/oder zu dem Ermittlungsverfahren gemäß dem ersten Aspekt der Erfindung beschrieben worden sind.

Ein erfindungsgemäßes Ermittlungsverfahren, ein Ermittlungssystem sowie ein Kraftfahrzeug werden nachfolgend anhand von Zeichnungen näher erläutert. Es zeigen jeweils schematisch:
- Figur 1: in einer Seitenansicht eine Ladeinfrastrukturvorrichtung und ein Kraftfahrzeug mit einem Ermittlungssystem,
- Figur 2: in einer funktionalen Ansicht eine Ladeinfrastrukturvorrichtung und ein Kraftfahrzeug mit einem Ermittlungssystem, und
- Figur 3: in einem Flussdiagramm eine erfindungsgemäße Ausgestaltung des Ermittlungsverfahrens.

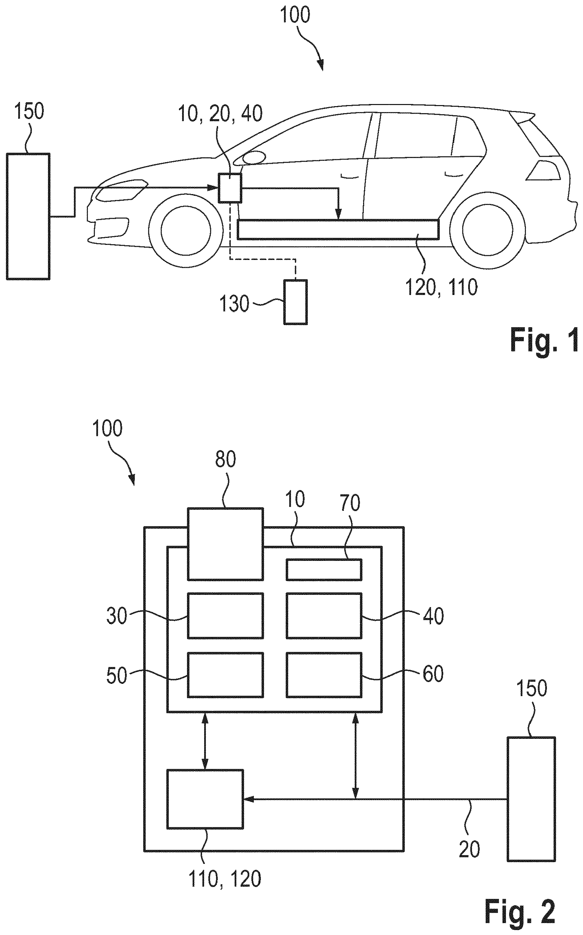

Elemente mit gleicher Funktion und Wirkungsweise sind in den Fig. 1 bis 3 jeweils mit denselben Bezugszeichen versehen.

In Fig. 1 ist schematisch in einer Seitenansicht eine Ladeinfrastrukturvorrichtung 150 und ein Kraftfahrzeug 100 mit einem Ermittlungssystem 10 gezeigt. Die Ladeinfrastrukturvorrichtung 150 stellt elektrische Energie an das Kraftfahrzeug 100 und den Energiespeicher 120 des Kraftfahrzeugs 100 zur Verfügung. Das Kraftfahrzeug 100 weist das erfindungsgemäße Ermittlungssystem 10 auf und ermöglicht ein Ermitteln 204 (nicht gezeigt) einer Differenz zwischen der maximal möglichen Empfangsleistung 110 des Kraftfahrzeugs 100 und der erfassten aktuellen Ladeleistung 20, wobei die erfasste Ladeleistung 20 mit der maximal möglichen Empfangsleistung 110 des Kraftfahrzeugs 100 durch eine Vergleichsvorrichtung 40 des Ermittlungssystems 10 verglichen wird. Das Ausgeben 206 (nicht gezeigt) einer Differenzmeldung umfasst das Initiieren 214 (nicht gezeigt) einer datenkommunizierenden Verbindung zwischen dem Ermittlungssystem 10 und einem mobilen Endgerät 130 und ein Senden einer Ausgabe der Differenzmeldung an das mobile Endgerät 130.

In Fig. 2 ist schematisch in einer funktionalen Ansicht eine Ladeinfrastrukturvorrichtung 150 und ein Kraftfahrzeug 100 mit einem Ermittlungssystem 10 gezeigt. Das Ermittlungssystem 10 weist eine Erfassungsvorrichtung 30 zum Erfassen 202 (nicht gezeigt) der aktuellen Ladeleistung 20, eine Vergleichsvorrichtung 40 zum Vergleichen der erfassten Ladeleistung 20 mit einer maximal möglichen Empfangsleistung 110 des Kraftfahrzeugs 100 zum Ermitteln 204 (nicht gezeigt) einer Differenz zwischen der maximal möglichen Empfangsleistung 110 des Kraftfahrzeugs 100 und der erfassten aktuellen Ladeleistung 20 und eine Ausgabevorrichtung 50 zum Ausgeben 206 (nicht gezeigt) einer Differenzmeldung auf Grundlage der ermittelten Differenz auf. Eine Detektionsvorrichtung 60 des Ermittlungssystems 10 ist zum Detektieren 208 (nicht gezeigt) eines Ladevorgangs ausgestaltet, wobei die Verfahrensschritte des Erfassens 202 (nicht gezeigt), des Ermittelns 204 (nicht gezeigt) und/oder des Ausgebens 206 (nicht gezeigt) in Abhängigkeit von einem detektierten Ladevorgang erfolgen. Eine Auswertevorrichtung 70 des Ermittlungssystems 10 ist zum Auswerten 212 (nicht gezeigt) einer Sensorvorrichtung 90 des Ermittlungssystems 10 zur Ermittlung von einem Begrenzungsfaktor für die erfasste aktuelle Ladeleistung 20 ausgestaltet, wobei der ermittelte Begrenzungsfaktor durch die Ausgabevorrichtung 50 ausgegeben wird. Das Erfassen 202 (nicht gezeigt) der aktuellen Ladeleistung 20 und das Ermitteln der maximal möglichen Empfangsleistung 110 erfolgt durch eine datenkommunizierende Verbindung der Erfassungsvorrichtung 30 mit zumindest einem Energiespeicher 120 des Kraftfahrzeugs 100. Das Ausgeben 206 (nicht gezeigt) der Differenzmeldung auf Grundlage der ermittelten Differenz umfasst ein Senden einer Ausgabe an eine Ladeinfrastrukturvorrichtung 150 durch eine Sendevorrichtung 80 des Ermittlungssystems 10.

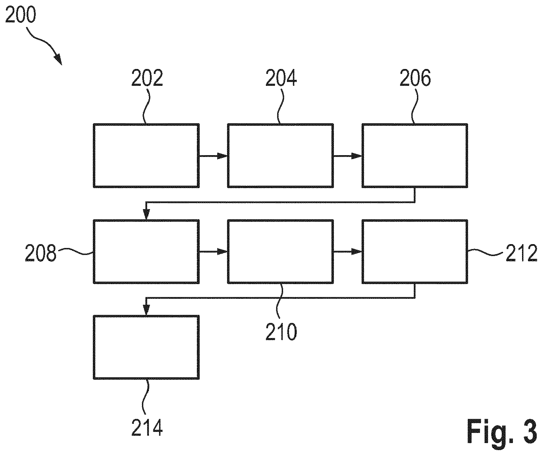

In Fig. 3 ist schematisch in einem Flussdiagramm eine erfindungsgemäße Ausgestaltung des Ermittlungsverfahrens 200 gezeigt. Für eine verbesserte Übersichtlichkeit sind in Fig. 3 nur die Bezugszeichen der Verfahrensschritte angegeben. Das Ermittlungsverfahren 200 umfasst in einem ersten Verfahrensschritt das Erfassen 202 der aktuellen Ladeleistung 20 durch eine Erfassungsvorrichtung 30 des Ermittlungssystems 10. Das Ermittlungsverfahren 200 umfasst in einem weiteren Verfahrensschritt das Ermitteln 204 einer Differenz zwischen der maximal möglichen Empfangsleistung 110 des Kraftfahrzeugs 100 und der erfassten aktuellen Ladeleistung 20, wobei die erfasste Ladeleistung 20 mit der maximal möglichen Empfangsleistung 110 des Kraftfahrzeugs 100 durch eine Vergleichsvorrichtung 40 des Ermittlungssystems 10 verglichen wird. Das Ermittlungsverfahren 200 umfasst in einem weiteren Verfahrensschritt das Ausgeben 206 einer Differenzmeldung auf Grundlage der ermittelten Differenz durch eine Ausgabevorrichtung 50 des Ermittlungssystems 10, wenn die erfasste Ladeleistung 20 geringer als die maximal mögliche Empfangsleistung 110 ist. Das Ermittlungsverfahren 200 umfasst in einem weiteren Verfahrensschritt das Detektieren 208 eines Ladevorgangs durch eine Detektionsvorrichtung 60 des Ermittlungssystems 10, wobei die Verfahrensschritte des Erfassens 202, des Ermittelns 204 und/oder des Ausgebens 206 in Abhängigkeit von einem detektierten Ladevorgang erfolgen. Das Ermittlungsverfahren 200 umfasst in einem weiteren Verfahrensschritt das Kategorisieren 210 der erfassten aktuellen Ladeleistung 20 in wenigstens zwei Kategorien in Abhängigkeit von der maximal möglichen Empfangsleistung 110 des Kraftfahrzeugs 100, wobei das Ausgeben der Differenzmeldung auf Grundlage des Kategorisierens 210, erfolgt. Das Ermittlungsverfahren 200 umfasst in einem weiteren Verfahrensschritt das Auswerten 212 einer Sensorvorrichtung 90 des Ermittlungssystems 10 durch eine Auswertevorrichtung 70 des Ermittlungssystems 10 zur Ermittlung von einem Begrenzungsfaktor für die erfasste aktuelle Ladeleistung 20, wobei der ermittelte Begrenzungsfaktor durch die Ausgabevorrichtung 50 ausgegeben wird. Das Ermittlungsverfahren 200 umfasst in einem weiteren Verfahrensschritt das Initiieren 214 einer datenkommunizierenden Verbindung zwischen dem Ermittlungssystem 10 und einem mobilen Endgerät 130, wobei das Ausgeben 206 der Differenzmeldung ein Senden einer Ausgabe an das mobile Endgerät 130 umfasst.

### Bezugszeichenliste

- 10: Ermittlungssystem
- 20: Ladeleistung
- 30: Erfassungsvorrichtung
- 40: Vergleichsvorrichtung
- 50: Ausgabevorrichtung
- 60: Detektionsvorrichtung
- 70: Auswertevorrichtung
- 80: Sendevorrichtung
- 90: Sensorvorrichtung

- 100: Kraftfahrzeug
- 110: Empfangsleistung
- 120: Energiespeicher

- 130: mobiles Endgerät

- 150: Ladeinfrastrukturvorrichtung

- 200: Ermittlungsverfahren
- 202: Erfassen
- 204: Ermitteln
- 206: Ausgeben
- 208: Detektieren
- 210: Kategorisieren
- 212: Auswerten
- 214: Initiieren

## Patentansprüche

1. Ermittlungsverfahren (200) zum Ermitteln einer Differenz zwischen einer maximal möglichen Empfangsleistung (110) eines Kraftfahrzeugs (100) und einer aktuellen Ladeleistung (20) eines Ladevorgangs durch ein Ermittlungssystem (10), das Ermittlungsverfahren (200) umfassend:
- Erfassen (202) der aktuellen Ladeleistung (20) durch eine Erfassungsvorrichtung (30) des Ermittlungssystems (10),
- Ermitteln (204) einer Differenz zwischen der maximal möglichen Empfangsleistung (110) des Kraftfahrzeugs (100) und der erfassten aktuellen Ladeleistung (20), wobei die erfasste Ladeleistung (20) mit der maximal möglichen Empfangsleistung (110) des Kraftfahrzeugs (100) durch eine Vergleichsvorrichtung (40) des Ermittlungssystems (10) verglichen wird,
- Ausgeben (206) einer Differenzmeldung auf Grundlage der ermittelten Differenz durch eine Ausgabevorrichtung (50) des Ermittlungssystems (10), wenn die erfasste Ladeleistung (20) geringer als die maximal mögliche Empfangsleistung (110) ist.

2. Ermittlungsverfahren (200) nach Anspruch 1,
**dadurch gekennzeichnet,**
**dass** das Ermittlungsverfahren (200) umfasst:
- Detektieren (208) eines Ladevorgangs durch eine Detektionsvorrichtung (60) des Ermittlungssystems (10), wobei die Verfahrensschritte des Erfassens (202), des Ermittelns (204) und/oder des Ausgebens (206) in Abhängigkeit von einem detektierten Ladevorgang erfolgen.

3. Ermittlungsverfahren (200) nach einem der vorangegangenen Ansprüche,
**dadurch gekennzeichnet,**
**dass** das Ermitteln (204) der Differenz ferner umfasst:
- Kategorisieren (210) der erfassten aktuellen Ladeleistung (20) in wenigstens zwei Kategorien in Abhängigkeit von der maximal möglichen Empfangsleistung (110) des Kraftfahrzeugs (100), insbesondere wobei das Ausgeben der Differenzmeldung auf Grundlage des Kategorisierens (210), erfolgt.

4. Ermittlungsverfahren (200) nach einem der vorangegangenen Ansprüche,
**dadurch gekennzeichnet,**
**dass** das Ermittlungsverfahren (200) umfasst:
- Auswerten (212) zumindest einer Sensorvorrichtung (90) des Ermittlungssystems (10) durch eine Auswertevorrichtung (70) des Ermittlungssystems (10) zur Ermittlung von zumindest einem Begrenzungsfaktor für die erfasste aktuelle Ladeleistung (20), wobei der zumindest eine ermittelte Begrenzungsfaktor durch die Ausgabevorrichtung (50) ausgegeben wird.

5. Ermittlungsverfahren (200) nach einem der vorangegangenen Ansprüche,
**dadurch gekennzeichnet,**
**dass** das Erfassen (202) der aktuellen Ladeleistung (20) und/oder das Ermitteln der maximal möglichen Empfangsleistung (110) durch eine datenkommunizierende Verbindung der Erfassungsvorrichtung (30) mit zumindest einem Energiespeicher (120) des Kraftfahrzeugs (100) erfolgt.

6. Ermittlungsverfahren (200) nach einem der vorangegangenen Ansprüche,
**dadurch gekennzeichnet,**
**dass** das Erfassen (202) der aktuellen Ladeleistung (20) durch eine datenkommunizierende Verbindung der Erfassungsvorrichtung (30) mit zumindest einer Ladeinfrastrukturvorrichtung (150) erfolgt.

7. Ermittlungsverfahren (200) nach einem der vorangegangenen Ansprüche,
**dadurch gekennzeichnet,**
**dass** das Ausgeben (206) der Differenzmeldung auf Grundlage der ermittelten Differenz als eine optische Ausgabe, insbesondere eine grafische Ausgabe, durch die Ausgabevorrichtung (50) erfolgt.

8. Ermittlungsverfahren (200) nach einem der vorangegangenen Ansprüche,
**dadurch gekennzeichnet,**
**dass** das Ausgeben (206) der Differenzmeldung auf Grundlage der ermittelten Differenz ein Senden einer Ausgabe an eine Ladeinfrastrukturvorrichtung (150) durch eine Sendevorrichtung (80) des Ermittlungssystems (10) umfasst.

9. Ermittlungsverfahren (200) nach einem der vorangegangenen Ansprüche,
**dadurch gekennzeichnet,**
**dass** das Ermittlungsverfahren (200) ferner umfasst:
- Initiieren (214) einer datenkommunizierenden Verbindung zwischen dem Ermittlungssystem (10) und einem mobilen Endgerät (130), wobei das Ausgeben (206) der Differenzmeldung ein Senden einer Ausgabe an das mobile Endgerät (130) umfasst.

10. Ermittlungssystem (10), aufweisend eine Erfassungsvorrichtung (30) zum Erfassen (202) der aktuellen Ladeleistung (20), eine Vergleichsvorrichtung (40) zum Vergleichen der erfassten Ladeleistung (20) mit einer maximal möglichen Empfangsleistung (110) des Kraftfahrzeugs (100) zum Ermitteln (204) einer Differenz zwischen der maximal möglichen Empfangsleistung (110) des Kraftfahrzeugs (100) und der erfassten aktuellen Ladeleistung (20) und eine Ausgabevorrichtung (50) zum Ausgeben (206) einer Differenzmeldung auf Grundlage der ermittelten Differenz,
**dadurch gekennzeichnet,**
**dass** das Ermittlungssystem (10) zum Ausführen des Ermittlungsverfahrens (200) gemäß einem der voranstehenden Ansprüche ausgestaltet ist.

11. Kraftfahrzeug (100), aufweisend zumindest ein Ermittlungssystem (10),
**dadurch gekennzeichnet,**
**dass** das Ermittlungssystem (10) gemäß Anspruch 10 ausgestaltet ist.
